# EUROPÄISCHE PATENTSCHRIFT

(11) **EP 1 014 194 B1**
(45) Veröffentlichungstag und Bekanntmachung des Hinweises auf die Patenterteilung: **24.07.2002**
(21) Anmeldenummer: 99124368.4
(22) Anmeldetag: 07.12.1999
(51) Int. Cl.: G03F 7/095, G03F 7/033, G03F 1/00

(54) **Photopolymerisierbare Druckformen mit Oberschicht zur Herstellung von Reliefdruckformen**
Photopolymerisable printing plates with top layer for the production of relief printing plates
Plaques d'impression photopolymérisables avec couche supérieure pour la production de plaques d'impression en relief

(30) Priorität: 23.12.1998 DE 19859623
(43) Veröffentlichungstag der Anmeldung: 28.06.2000
(73) Patentinhaber: BASF Drucksysteme GmbH, 70469 Stuttgart (DE)
(72) Erfinder: Zwez, Thomas, Dr., 76199 Karlsruhe (DE); Wegener, Stefan, Dr., 55124 Mainz (DE)
(74) Vertreter: Stark, Vera, Dr.

(56) Entgegenhaltungen:
- EP-A- 0 456 336
- WO-A-94/03838

## Beschreibung

Die vorliegende Erfindung betrifft eine photopolymerisierbare Druckform mit einem dimensionsstabilen Träger, einer photopolymerisierbaren Schicht, einer darauf befindlichen Oberschicht sowie einer Schutzfolie, wobei die Oberschicht zwei nicht miteinander verträgliche elastomere Blockcopolymere enthält. Sie betrifft weiterhin ein Verfahren zur Herstellung einer derartigen photopolymerisierbaren Druckform, ein Verfahren zur Herstellung von Reliefdruckformen, insbesondere von Flexodruckplatten, sowie Reliefdruckformen mit Näpfchen in der Oberfläche des Reliefs.

Photopolymerisierbare Druckformen sind prinzipiell bekannt und weisen im allgemeinen eine photopolymerisierbare Schicht auf, die ein polymeres Bindemittel, eine photopolymerisierbare Verbindung, einen Photopolymerisationsinitiator oder -initiatorsystem und gegebenenfalls weitere übliche Bestandteile enthält. Für die Herstellung von Flexodruckplatten werden zumeist elastomere Bindemittel wie Block-Copolymere, zum Beispiel Dreiblock-Copolymere mit Styrol-Isopren-Styrol-Blöcken oder Styrol-Butadien-Styrol-Blöcken bevorzugt, wie sie zum Beispiel in der DE-A 22 15 090 beschrieben sind. Druckplatten, die diese Elastomeren als Bindemittel enthalten, sind weich und elastisch und können deshalb sehr gut im Flexodruck eingesetzt werden.

Maßgeblichen Einfluss auf das Druckverhalten hat die Oberfläche der Druckform. Parameter wie Rauigkeit, Abrasivität, Oberflächenspannung, Oberflächenklebrigkeit oder Lösungsmittelbeständigkeit haben großen Einfluss auf den Farbübertrag und das Ausdruckverhalten. Es ist bekannt, Druckplatten aus mehreren Schichten, insbesondere aus zwei Schichten aufzubauen. Der zweischichtige Aufbau einer Druckform aus einer photopolymerisierbaren Schicht und einer darauf befindlichen, vergleichsweise dünnen Oberschicht, hat den Vorteil dass die Eigenschaften der Oberfläche der Druckform verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

EP-A 084 851 offenbart ein Verfahren zur Herstellung einer photopolymerisierbaren Druckplatte mit Oberschicht. Zunächst wird ein sogenanntes Deckelement hergestellt, indem die Oberschicht durch Gießen oder Extrudieren auf eine Deckfolie aufgebracht wird. Anschließend wird in den Spalt eines Kalanders eine heiße, extrudierte Photopolymermasse eingeführt und zwischen einen Träger und das Deckelement kalandriert, wodurch eine photopolymerisierbare Schicht zwischen ihnen gebildet wird. Die Oberschicht umfasst ein elastomeres Bindemittel und optional ein zweites, nicht elastomeres Bindemittel, insbesondere ein Methylmethacrylat/Acrylnitril/Butadien/Styrol-Tetrapolymer.

EP-A 456 336 offenbart ein photopolymerisierbares Druckelement mit einer Oberschicht aus zwei elastomeren Polymeren als Bindemittel; einem vernetzenden Blockcopolymeren und einem, welches ein Acrylnitril/Butadien- oder Acrylnitril/Isopren-Copolymer, carboxyliertes Acrylnitril oder ein Polyacrylat sein kann.

DE-A 40 22 978 offenbart eine photopolymerisierbare Druckplatte mit einer entklebenden Oberschicht die ein radiales (Polystyrol/Polybutadien)₄Si-Blockcopolymer und optional zusätzlich ein Methylmethacrylat/Acrylnitril/Butadien/Styrol-Tetrapolymer enthält. Die derartig gestaltete Oberschicht soll verhindern, dass die Bildmaske während des Belichtens auf der Oberfläche der Platte festklebt.

Die acrylnitrilhaltigen Polymere werden beim Belichten der photopolymerisierbaren Druckplatten in Form kleiner Kügelchen in die Oberschicht einvernetzt, so dass die Oberfläche des druckenden Reliefs der polymerisierten und entwickelten Druckplatte mit kleinen Kügelchen besetzt ist.

Die geschilderten Druckformen werden nach dem Belichten mit chlorhaltigen Lösungsmitteln wie Tetrachlorethylen oder Gemischen aus Tetrachlorethylen und n-Butanol entwickelt. Aus ökologischen Gründen werden mittlerweile aber üblicherweise chlorfreie Auswaschmittel auf Basis von hochsiedenden Kohlenwasserstofflösungsmitteln verwendet, wie bspw. von EP-A 470 071 offenbart. In diesen sind die acrylnitril- und methacrylathaltigen Polymere aber weitgehend unlöslich, so dass es in den Wäschern zur Polymerabscheidung (Schlammbildung) kommt, was erhöhten Reinigungsaufwand zur Folge hat.

Des Weiteren ist es im Interesse einer wirtschaftlichen Produktion von Druckplatten erforderlich, dass die Eigenschaften der Oberfläche einer Druckplatte ohne hohen apparativen Aufwand auf einfache Art und Weise kontrolliert verändert werden können, um die Oberfläche individuell für den jeweils gewünschten Anwendungszweck gestalten zu können.

Aufgabe der vorliegenden Erfindung war es, eine photopolymerisierbare Druckform mit einer Oberschicht zur Verfügung zu stellen, die problemlos mit chlorfreien Auswaschmitteln entwickelbar ist. Aufgabe war es weiterhin, eine Druckform bereitzustellen, deren Oberfläche auf einfache Art und Weise individuell für den jeweils gewünschten Anwendungszweck gestaltet werden kann, und die dennoch klebfrei ist und eine hervorragende Farbannahme zeigt.

Dementsprechend wurde eine photopolymerisierbare Druckform mit einem dimensionsstabilen Schichtträger, einer photopolymerisierbaren Schicht sowie einer darauf aufgebrachten elastomeren Oberschicht und einer Schutzfolie gefunden.

Die erfindungsgemäße Druckform ist dadurch gekennzeichnet, dass die elastomere Oberschicht
- 40 - 95 Gew.-% eines vernetzbaren elastomeren Blockcopolymeren A aus vinylaromatischen und Dienblöcken, sowie
- 5 - 50 Gew.-% eines nicht vernetzbaren elastomeren Blockcopolymeren B aus vinylaromatischen und Alkylenblöcken enthält,
und die Blockcopolymere A und B nicht miteinander verträglich sind.

Erfindungsgemäß wurde weiterhin eine Reliefdruckform mit Näpfchen in der Oberfläche des druckenden Reliefs gefunden, die aus einer photopolymerisierbaren Druckform der oben angegebenen Art hergestellt werden kann. In der Regel weisen diese Näpfchen einen Durchmesser und eine Tiefe von nicht mehr als 15 µm, bevorzugt von nicht mehr als 10 µm auf.

Die erfindungsgemäßen Reliefdruckformen mit Näpfchen in der Oberfläche zeichnen sich durch eine klebfreie Oberfläche und eine hervorragende Farbannahme aus. Ihre Oberflächeneigenschaften, insbesondere ihre Rauigkeit, können auf besonders einfache Art und Weise optimal an den jeweils gewünschten Anwendungszweck angepasst werden können.

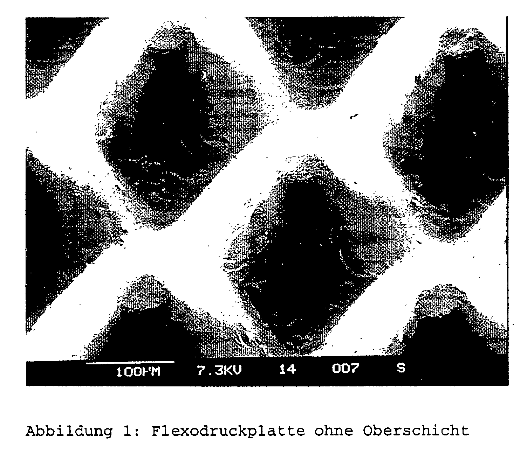

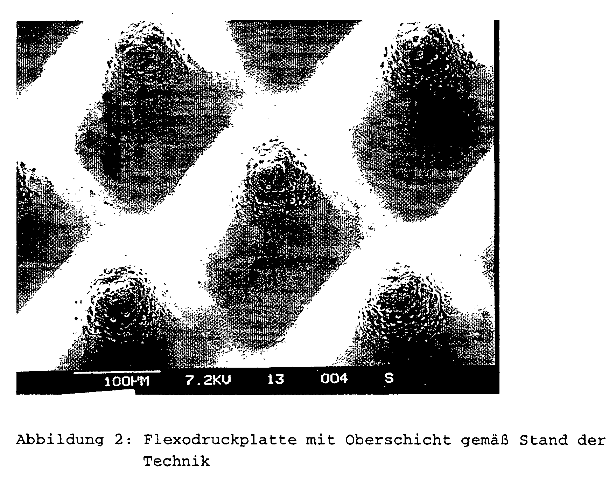

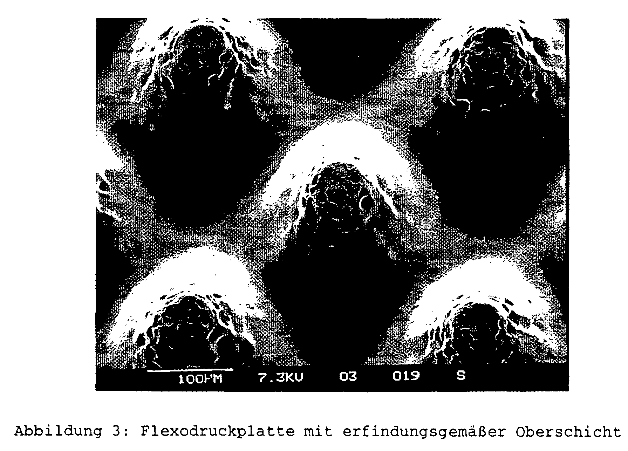

Die Erfindung wird auch durch die beigefügten Abbildungen erläutert. Abbildungen 1 bis 3 zeigen elektronenmikroskopische Aufnahmen einzelner Rasterpunkte verschiedener Flexodruckplatten.

Abbildung 1 zeigt eine Flexodruckplatte ohne Oberschicht.

Abbildung 2 zeigt eine Flexodruckplatte mit Oberschicht gemäß dem Stand der Technik, hergestellt aus einem photopolymeren Druckelement mit einer Oberschicht aus einem SIS-Blockcopolymeren und einem Methylmethacrylat/Acrylnitril/Butadien/Styrol-Tetrapolymeren. Die Flexodruckplatte weist Kügelchen in der Oberfläche auf.

Abbildung 3 zeigt eine Flexodruckplatte mit einer erfindungsgemäßen Oberschicht, hergestellt aus einem photopolymeren Druckelement mit einer Oberschicht aus einem vernetzenden SIS-Blockcopolymeren und einem nicht vernetzenden SEBS-Blockcopolymeren. Die Flexodruckplatte weist Näpfchen in der Oberfläche auf.

Abbildung 4 zeigt einen Schnitt durch die Oberschicht einer erfindungsgemäßen photopolymerisierbaren Druckform mit Domänen von B in einer kontinuierlichen Phase von A (Maßstab 260:1).

Bei der erfindungsgemäßen photopolymerisierbaren Druckform ist eine photopolymerisierbare Schicht gegebenenfalls mit einer Haftschicht auf einen dimensionsstabilen Träger aufgebracht. Beispiele geeigneter dimensionsstabiler Träger sind Platten, Folien sowie konische und zylindrische Röhren (sleeves) aus Metallen wie Stahl, Aluminium, Kupfer oder Nickel oder aus Kunststoffen wie Polyethylenterephthalat (PET), Polybutylenterephthalat, Polyamid, Polycarbonat, gegebenenfalls auch Gewebe und Vliese, wie Glasfasergewebe sowie Verbundmaterialien aus Glasfasern und Kunststoffen. Als dimensionsstabile Träger kommen insbesondere dimensionsstabile Trägerfolien, beispielsweise Polyethylen- oder Polyesterfolien, insbesondere Polyethylenterephthalatfolien in Frage. Diese Trägerfolien sind im allgemeinen zwischen 50 und 500 µm, vorzugsweise 75 bis 400 µm, beispielsweise ca. 125µm dick. Der Schichtträger kann mit einer weichelastischen Unterschicht unterlegt sein.

Als Haftschichten können unter anderem Polyurethanhaftlacke, z.B. gemäss DE-A-30 45 516 auf Basis von polyisocyanatvernetzenden Polyether- oder Polyesterlacken in Schichtdicken zwischen 0,5 und 50 µm, insbesondere zwischen 2 und 30 µm dienen.

Die photopolymerisierbare Schicht besteht aus einem photopolymerisierbaren Gemisch, welches negativ arbeitet, d.h. durch Belichtung gehärtet wird. Dies kann durch Photovernetzung mit vorgefertigten Polymeren, durch Photopolymerisation von niedermolekularen, photopolymerisierbaren Verbindungen oder beides erfolgen. Photopolymerisierbare Schichten enthalten im wesentlichen ein polymeres, im Entwickler auswaschbares Bindemittel, eine ethylenisch ungesättigte, radikalisch polymerisierbare Verbindung, einen Photoinitiator oder ein Photoinitiatorsystem sowie optional weitere Additive und Hilfsstoffe. Die Zusammensetzung derartiger Schichten ist prinzipiell bekannt und beispielsweise in DE-A 24 56 439 oder EP-A 084 851 beschrieben.

Mit besonderem Vorteil werden als Bindemittel Elastomere eingesetzt, zum Beispiel Blockcopolymere mit starren Polymerblöcken aus Styrol-, Acrylnitril oder Acrylestereinheiten und elastischen Blöcken aus Dienpolymerisaten wie z.B. von Butadien oder Isopren. Geeignet sind beispielsweise elastomere Dreiblockcopolymere mit Styrol-Isopren-Styrol- oder Styrol-Butadien-Styrol-Blöcken, wie beispielsweise in DE-A 22 15 090 beschrieben. Die Dreiblockcopolymere können als einzige Elastomere oder auch im Gemisch mit Zweiblockcopolymeren, zum Beispiel Styrol-Isopren- oder Styrol-Butadien-Zweiblockcopolymeren eingesetzt werden. Von besonderem Vorteil werden Dreiblockcopolymere mit endständigen Styrolblöcken und einem statistisch aus Styrol und Butadien aufgebauten elastomeren Mittelblock eingesetzt, wie in DE -Aktenzeichen P 198 46 529.7 beschrieben.

Die photopolymerisierbaren Gemische enthalten weiterhin in bekannter Weise polymerisierbare Verbindungen, beziehungsweise Monomere. Die Monomeren sollen mit dem Bindemittel verträglich sein und mindestens eine polymerisierbare ethylenische Doppelbindung aufweisen. Geeignete Monomere haben im allgemeinen einen Siedepunkt von mehr als 100°C bei Atmosphärendruck und ein Molekulargewicht bis zu 3000 g/mol, vorzugsweise bis zu 2000 g/mol. Als besonders vorteilhaft haben sich Ester oder Amide der Acryl- oder Methacrylsäure, Styrol oder substituierte Styrole, Ester der Fumar- oder Maleinsäure oder Allylverbindungen erwiesen. Geeignete Monomere sind in der EP-A 326 977, Seite 5 genannt.

Als Initiatoren für die Photopolymerisation sind unter anderen Benzoin oder Benzoinderivate, wie α-Methylbenzoin oder Benzoinether, Benzilderivate, wie Benzilketale, Acylarylphosphinoxide, Acylarylphosphinsäureester, Mehrkernchinone oder Benzophenone geeignet.

Die photopolymerisierbaren Gemische enthalten in der Regel 45 bis 95 Gew.-% des Bindemittels bzgl. der Summe aller Bestandteile. Vorzugsweise werden 70 bis 95 Gew.-% des Bindemittels eingesetzt. Die Menge der polymerisierbaren Monomeren liegt im Bereich von 4,9 bis 45 Gew.-%, bevorzugt zwischen 4,9 und 30 Gew.-%. Die Menge an Photoinitiator beträgt 0,1 bis 5 Gew.-%.

Die photopolymerisierbaren Gemische können darüber hinaus Weichmacher enthalten. Beispiele für geeignete Weichmacher sind modifizierte oder unmodifizierte Naturöle und -harze, Alkyl-, Alkenyl-, Arylalkyl- oder Arylalkenylester von Säuren, wie Alkansäuren, Arylcarbonsäuren oder Phosphorsäure; synthetische Oligomere oder Harze wie Oligostyrol, oligomere Styrol-Butadien-Copolymere, oligomere α-Methylstyrol/p-Methylstyrol-Copolymere, flüssige Oligobutadiene, oder flüssige oligomere Acrylnitril-Butadien-Copolymere; sowie Polyterpene, Polyacrylate, Polyester oder Polyurethane, Polyethylen, Ethylen-Propylen-Dien-Kautschuke oder α-Methyl-Oligo(ethylenoxid). Beispiele besonders gut geeigneter Weichmacher sind paraffinische Mineralöle; Ester von Dicarbonsäuren wie Dioctyladipat oder Terephthalsäuredioctylester; naphthenische Weichmacher oder Polybutadiene mit einem Molgewicht zwischen 500 und 5000 g/mol. Es können auch Gemische verschiedener Weichmacher eingesetzt werden. Die Menge des gegebenenfalls enthaltenen Weichmachers wird vom Fachmann entsprechend der gewünschten Härte der Druckplatte gewählt. Sie liegt in der Regel unter 40 Gew.-% bzgl. der Summe aller Bestandteile des photopolymerisierbaren Gemischs.

Die photopolymerisierbaren Gemische können ferner übliche Hilfsstoffe enthalten, vor allem Inhibitoren für die thermisch initiierte Polymerisation, Farbstoffe, Pigmente, photochrome Zusätze, Antioxidantien, Antiozonantien oder Extrusionshilfsmittel. Ihre Menge liegt im allgemeinen unter 20 Gew.-% bzgl. der Summe aller Bestandteile des photopolymerisierbaren Gemischs und wird vorteilhaft so gewählt, dass die Gesamtmenge aus Weichmacher und Hilfsmitteln 50 Gew.-% bzgl. der Summe aller Bestandteile nicht übersteigt.

Beispiele für Inhibitoren für die thermisch initiierte Polymerisation sind Hydrochinon, p-Methoxyphenol, 2,6-Di-tert.-butylp-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine.

Farbstoffe oder Pigmente können in einer Menge von bis zu 2 Gew.-% zugesetzt werden und dienen der Steuerung der Belichtungseigenschaften, der direkten Kontrolle des Belichtungsergebnisses oder ästhetischen Zwecken. Voraussetzung für die Auswahl und die Menge solcher Zusätze ist es, daß sie - ebenso wie die Inhibitoren - die Photopolymerisation der Gemische nicht stören. Geeignet sind insbesondere Azofarbstoffe, wie beispielsweise in DE-A 42 02 332 offenbart.

Beispiele für Antioxidantien sind sterisch gehinderte Monophenole, wie 2,6-Di-tert.-butyl-p-kresol; alkylierte Thiobis- und Alkylidenbisphenole; Hydroxybenzyle, wie 1,3,5-Trimethyl-2,4,6-tris-(3,5-di-tert.-butyl-4-hydroxybenzyl)benzol; Triazine; Dilaurylthiodipropionat; oder Phosphite, wie Tris(nonylphenyl)phosphit.

Als Extrusionshilfsmittel können beispielsweise α-Methylstyrol/Vinyltoluol-Copolymere eingesetzt werden.

Beispiele für Antiozonantien sind die üblichen und bekannten Ozonschutzwachse sowie Chloralkane mit 8 bis 40 Kohlenstoffatomen und 30 bis 73 Gew.-% Chlor im Molekül.

Die Dicke der photopolymerisierbaren reliefbildenden Schicht richtet sich in erster Linie nach dem Verwendungszweck der erfindungsgemäßen photopolymerisierbaren Druckformen. So variiert die Dicke im allgemeinen von 0,05 bis 7 mm, vorzugsweise 0,1 bis 7 mm und insbesondere 0,7 bis 6,5 mm. Sie wird vom Fachmann gemäß den Anforderungen der jeweils gewünschten Anwendung gewählt.

Bei der erfindungsgemäßen photopolymerisierbaren Druckform ist auf der photopolymerisierbaren Schicht eine elastomere Oberschicht aufgebracht. Die elastomere Oberschicht ist entweder selbst photopolymerisierbar oder wird durch den Kontakt mit der photopolymerisierbaren Schicht photopolymerisierbar.

Die elastomere Oberschicht enthält 40 - 95 Gew.-% bzgl. der Summe aller Bestandteile der Oberschicht eines vernetzbaren elastomeren Blockcopolymeren A aus vinylaromatischen Blöcken und Dienblöcken. Bei dem Blockcopolymeren A kann es sich um Zweiblock-, Dreiblock-, Mehrblockcopolymere oder um radiale Blockcopolymere handeln. Bevorzugt handelt es sich um Dreiblockcopolymere mit endständigen vinylaromatischen Blöcken und mittelständigen Dienblöcken. Die vinylaromatischen Blöcke können beispielsweise aus Styrol, α-Methylstyrol oder alkylsubstituierten Styrolen, wie beispielsweise 4-Methylstryrol aufgebaut sein. Die Dienblöcke können aus konjugierten aliphatischen Diolefinen, wie beispielsweise Butadien, alkylsubstituierten Butadienen, halogensubstituierten Butadienen oder Gemischen davon aufgebaut werden. Bevorzugt werden die Dienblöcke aus Butadien oder Isopren aufgebaut. Es ist möglich, wenngleich nicht bevorzugt, dass der Dienblock teilweise hydriert wird. Es müssen aber noch ausreichend Doppelbindungen im Dienblock verbleiben, so dass das Blockcopolymere A vernetzbar und unverträglich mit dem Blockcopolymeren B ist. Bevorzugt handelt es sich bei dem elastomeren Blockcopolymeren A um ein Dreiblockcopolymeres aus Polystyrol- und Polybutadienoder Polyisoprenblöcken. Es können auch Gemische verschiedener Blockcopolymerer A eingesetzt werden.

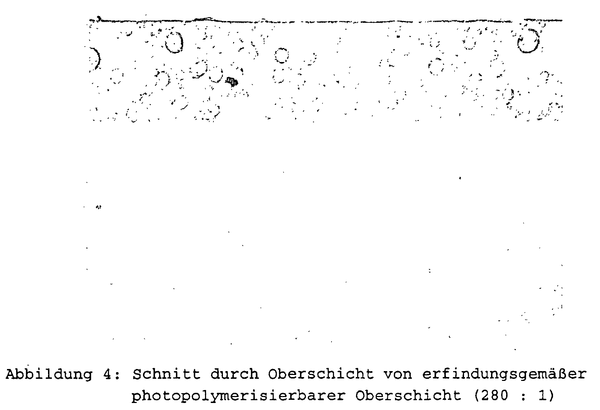

Des Weiteren enthält die elastomere Oberschicht 5 - 50 Gew.% eines nicht vernetzbaren elastomeren Blockcopolymeren B aus vinylaromatischen Blöcken und Alkylenblöcken, welches mit dem vernetzbaren Blockcopolymeren A nicht verträglich ist. Unter dem Begriff "nicht verträglich" ist zu verstehen, dass die beiden Blockcopolymeren nicht homogen miteinander mischbar sind, sondern dass das Blockcopolymer B in Form von diskreten Domänen oder Inseln, die im wesentlichen aus dem Blockcopolymeren B bestehen in einer im wesentlichen aus dem Blockcopolymeren A bestehenden kontinuierlichen Phase verteilt ist. Der Durchmesser der Domänen beträgt in der Regel nicht mehr als 15 µm, bevorzugt 5 - 10 µm. Die Domänen lassen sich nach geeigneter Kontrastierung der Schicht, bspw. mit OsO₄, unter dem Elektronenmikroskop als Tröpfchen oder Kugeln (siehe Abbildung 4) erkennen. Die Blockcopolymeren B sind nicht vernetzbar, d.h. sie enthalten keine oder allenfalls unbedeutende Mengen an polymerisierbaren Doppelbindungen in den mittelständigen Blöcken.

Bei dem Blockcopolymeren B kann es sich um Zweiblock-, Dreiblock-, Mehrblockcopolymere oder um radiale Blockcopolymere handeln. Bevorzugt handelt es sich um Dreiblockcopolymere mit endständigen vinylaromatischen Blöcken und mittelständigen Alkylenblöcken. Die vinylaromatischen Blöcke können wie oben geschildert aufgebaut sein. Die Blöcke aus Alkyleneinheiten sind herstellbar durch Polymerisation von Olefinen, zum Beispiel von Ethen, Propen, 1-Buten, 1-Hexen und ähnlichen Monoolefinen, oder durch Hydrierung von vorgefertigten Blöcken von Dienpolymerisaten, zum Beispiel von Polybutadien. Bei der Hydrierung entstehen in Abhängigkeit davon, ob die Butadieneinheiten im Polymeren durch 1,2 oder 1,4-Addition gebildet worden sind, Ethylen oder 1,2-Butyleneinheiten. Die Hydrierung kann in bekannter Art und Weise vorgenommen werden, wie beispielsweise in der US 3,431,323 beschrieben. Bei den Alkylenblöcken handelt es sich vorzugsweise um Polyethylen/-propylen- oder um Polyethylen/-butylen-Blöcke. Derartige Produkte sind bekannt und im Handel erhältlich. Es können auch Gemische verschiedener Blockcopolymerer B eingesetzt werden.

Das Verhältnis der Mengen der beiden Blockcopolymere A und B in der Oberschicht kann innerhalb der oben angegebenen Grenzen je nach den gewünschten Eigenschaften der fertigen Druckform gewählt werden. In der Regel ist das Verhältnis A/B größer als 50:50. Bevorzugt liegt das Verhältnis A/B zwischen 60:40 und 90:10, besonders bevorzugt zwischen 70:30 und 85:15.

Die elastomeren Bindemittel werden außerdem vorteilhaft so gewählt, dass sie sind im Entwickler für die photopolymerisierbare Schicht löslich oder zumindest quellbar sind.

Die erfindungsgemäße Oberschicht kann weiterhin polymerisierbare, ethylenisch ungesättigte Monomere sowie Photoinitiatoren oder Photoinitiatorsysteme enthalten. Dabei können diejenigen Verbindungen eingesetzt werden, die auch in der photopolymerisierbaren Schicht eingesetzt werden. Sie kann darüber hinaus auch noch weitere Additive und Zusatzstoffe, wie bspw. thermische Stabilisatoren, Farbpigmente oder Farbstoffe enthalten.

Bevorzugt enthält die erfindungsgemäße Oberschicht einen migrationsstabilen Farbstoff oder ein migrationsstabiles Farbpigment bzw. deren Zubereitungen. Geeignete Farbpigmente sind bspw. Cu-Phthalocyanine (bspw. Sicodop®-Blau) oder Perylenpigmente (bspw. Paliogenrot®). Die Farbpigmente werden in der Regel als vordispergierte Pigmentzubereitungen im Gemisch mit geeigneten Dispergierhilfsmitteln und/oder Bindemitteln eingesetzt.

Besonders bevorzugt enthält die erfindungsgemäße Oberschicht einen migrationsstabilen polymeren Farbstoff, bei dem das Chromophor entweder Bestandteil oder Endgruppe einer Polymerkette ist, oder als Seitengruppe an eine Polymerkette gepfropft ist. Vorteilhaft ist der polymere Farbstoff im Auswaschmittel löslich. Geeignet sind insbesondere polymere Farbstoffe, die sich durch die allgemeine Formel Chr-(X)ₙ wiedergeben lassen, wobei Chr ein organisches Chromophor und X eine unverzweigte oder verzweigte Polyoxyalkylenkette ist. Das Chromophor ist kovalent über eine Ankergruppe mit dem Polymer verbunden. Als Ankergruppen kommen beispielsweise Atome oder Gruppen wie -N<, -O-, -S-, -SO₂-, -CO₂-, -(CO)N< oder -(CO)NH- in Frage. Bei der Polyoxyalkylenkette handelt es sich bevorzugt um Homo- oder Copolymere aus Ethylenoxy- , Propylenoxy- oder Butylenoxyeinheiten, die gegebenenfalls noch weitere verträgliche Monomere in geringen Mengen enthalten können. n stellt die Anzahl der Polymerketten pro Chromophor dar und kann zwischen 1 und 6 liegen. Bevorzugte organische Chromophore sind Azoverbindungen. Derartige polymere Farbstoffe sind prinzipiell bekannt. Die Synthese ist beispielsweise in US 3,157,633 oder US 4,167,510 offenbart. Sie sind unter dem Namen Reactint® kommerziell (Fa. Milliken) erhältlich.

Die Menge der zugesetzten Farbstoffe, Farbpigmente bzw. deren Zubereitungen richtet sich nach dem jeweiligen Anwendungszweck und den gewünschten Eigenschaften. Die Menge aller zugesetzten Hilfsund Zusatzstoffe sollte aber in der Regel 5 Gew.-%, bevorzugt 3 Gew.-% bzgl. aller Bestandteile der Oberschicht nicht überschreiten.

Die Oberschicht ist in der Regel dünn gegenüber der photopolymerisierbaren Schicht. Bevorzugt beträgt die Dicke der Oberschicht 5 - 200 µm, besonders bevorzugt 20 - 150 µm.

Außerdem enthält das erfindungsgemäße Aufzeichnungsmaterial üblicherweise eine lichtdurchlässige, in den Entwicklern für die Photopolymerschicht lösliche oder quellbare Entklebungsschicht, welche an der Oberschicht fester haftet als an der Schutzfolie und welche von einem reissfeste Filme bildenden Polymeren und den gegebenenfalls darin enthaltenen Zusatzstoffen gebildet wird. Beispiele geeigneter, reissfester Filme bildender Polymerer sind Polyamide, voll- oder teilverseifte Polyvinylacetate oder Polyethylenoxid/Vinylacetat-Pfropfpolymerisate, Copolyamide, Polyurethane, Poly(meth)acrylate, Polyvinyl-alkohol-alkancarbonsäureester eines Hydrolysegrades von 30 bis 99 %, Cyclokautschuke hohen Cyclisierungsgrads, Ethylen/Propylen-Copolymerisate, Homound Copolymerisate des Vinylchlorids oder Ethylen/Vinylacetat-Copolymerisate. Beispiele geeigneter Entklebungsschichten, welche Zusatzstoffe enthalten, sind aus der DE-A 28 23 300 oder der DE-B 21 23 702 bekannt. Im allgemeinen sind die Entklebungsschichten 0,2 bis 25 µm dick. Sie erleichtern das Abziehen der Schutzfolie ohne Beschädigung darunter liegender Schichten.

In einer besonderen Ausführungsform der Erfindung befindet sich auf der Entklebungsschicht oder vorzugsweise zwischen der Oberschicht und der Entklebungsschicht eine gegen IR-Stahlung empfindliche Schicht. Die IR-empfindliche Schicht ist IR-ablativ, d.h. sie kann durch Bestrahlung mit einem IR-Laser, vorzugsweise einem Nd/YAG-Laser, teilweise abgetragen, d.h. bildmäßig beschrieben werden. Derartige IR-empfindliche Schichten sind beispielsweise aus der EP-A 767 407 bekannt.

Die gegen IR-Strahlung empfindliche Schicht ist im Entwickler löslich oder dispergierbar und enthält in einem filmbindenden Bindemittel mit elastomeren Eigenschaften mindestens eine feinverteilte Substanz, die eine hohe Absorption im Wellenlängenbereicht zwischen 750 und 20000 nm und im aktinischen Bereich eine optische Dichte grösser 2,5 aufweist. Es kann sich dabei um Entwickler auf Wasser- bzw. Wasser/Alkohol-Basis handeln oder auf Basis von organischen Lösungsmitteln. Als Bindemittel eignen sich für die IR-empfindliche Schicht Polymerisate, insbesondere Copolymerisate, die wasser- bzw. alkohollöslich oder -dispergierbar sind, oder solche, die in organischen Lösungsmitteln oder Lösungsmittelgemischen löslich oder dispergierbar sind.

Beispiele für in Wasser bzw. Wasser/Alkohol-Gemischen lösliche oder dispergierbare Bindemittel mit elastomeren Eigenschaften sind Polyvinylalkohol/Polyethylenglykol- Copolymere (z.B. Mowiol® GE 5-97 der Fa. Hoechst), die durch Propfen von Vinylacetat auf Polyethylenglykol mit Molekulargewichten zwischen 1000 und 50 000 und anschließender Verseifung bis zu einem Verseifungsgrad zwischen 80 und 100 % erhältlich sind.

Beispiele für in organischen Lösungsmitteln oder -gemischen lösliche oder dispergierbare Bindemittel mit elastomeren Eigenschaften sind thermoplastisch-elastomere Polyamid-Harze, die kommerziell erhältlich sind (bspw. Macromelt®, Fa. Henkel). Die genannten Produkte sind in den jeweiligen Firmenschriften ausführlich beschrieben.

Beispiele für die im filmbindenden Bindemittel der IR-empfindlichen Schicht enthaltenen feinverteilten Substanzen sind verschiedene feinteilige Rußarten, z.B. Farbruß FW 2000, Spezialschwarz 5 oder Printex® U der Fa. Degussa mit einer mittleren Primärteilchengröße von 13 bis 30 nm.

Die photopolymerisierbare Druckform wird gegen mechanische Beschädigungen durch eine, z.B. aus PET bestehende, Schutzfolie geschützt, die sich auf der jeweils obersten Schicht befindet.

Die erfindungsgemäße photopolymerisierbare Druckform kann hergestellt werden, indem man einen Schichtenverbund umfassend -in dieser Reihenfolge- eine Schutzfolie, eine Entklebungsschicht, optional eine IR-ablative Schicht und eine Oberschicht herstellt und auf eine photopolymerisierbare Schicht auf einem dimensionsstabilen Träger aufbringt. Die photopolymerisierbare Schicht und die Oberschicht werden dabei direkt miteinander verbunden, d.h. es befindet sich keine weitere Schicht zwischen den beiden Schichten. Vorteilhaft, wenngleich nicht auf diese Vorgehensweise beschränkt, kann das Aufbringen in der aus EP-A 084 851 bekannten Art und Weise so erfolgen, dass in den Spalt eines Kalanders eine heiße, extrudierte Photopolymermasse eingeführt und zwischen einen dimensionsstabilen Träger und den Schichtenverbund kalandriert wird.

Der Schichtenverbund kann hergestellt werden, indem man die Schutzfolie zunächst mit einer Entklebungsschicht und optional mit einer IR-ablativen Schicht beschichtet. Die Herstellung der Entklebungsschicht erfolgt bevorzugt durch Auflösen des reissfesten Polymers in einem geeigneten Lösungsmittel, gefolgt vom Aufgießen der Lösung und Verdampfen des Lösungsmittels. Für die Herstellung der IR-ablativen Schicht verwendet man vorteilhafterweise eine Lösung des Bindemittels, in der die Substanzen mit hoher IR-Absorption homogen dispergiert sind. Diese Lösung wird entweder direkt auf die Entklebungsschicht gleichmäßig aufgetragen und getrocknet oder auf eine Folie gegossen, getrocknet und die Schicht nach Abziehen der Folie auf die Entklebungsschicht aufkaschiert.

Die Oberschicht wird aufgebracht, indem man Blockcopolymer A und Blockcopolymer B sowie optional vorhandene Zusatzstoffe, Farbstoffe, Farbpigmente oder deren Zubereitungen in einem geeigneten Lösungsmittel oder Lösungsmittelgemisch löst. Der Lösevorgang wird vorteilhaft durch intensives Durchmischen des Ansatzes mittels eines geeigneten Rühr- oder Dispergieraggregates sowie gegebenenfalls durch Erwärmen unterstützt. Die Lösung wird anschließend als dünne Schicht auf die mit einer Entklebungsschicht beschichte Schutzfolie oder -falls vorhanden- die IR-ablatierbare Schicht aufgegossen und das wird Lösungsmittel kontrolliert verdampft. Im Zuge des Verdampfens des Lösungsmittels separieren die beiden miteinander unverträglichen Blockcopolymere A und B, und es bildet sich die oben geschilderten Struktur aus Inseln des Blockcopolymeren B in einer kontinuierlichen Phase aus Blockcopolymer A.

Geeignete Lösungsmittel für die beiden miteinander unverträglichen Blockcopolymere aliphatische Kohlenwasserstoffe, cyclyaliphatische Kohlenwasserstoffe wie bspw. Cyclohexan aromatische Kohlenwasserstoffe wie bspw. Toluol, Ethylbenzol oder Xylol, chlorierte Kohlenwasserstoffe wie bspw. Methylenchlorid oder Chloroform. Es können auch Gemische verschiedener Lösungsmittel eingesetzt werden. Weiterhin können die Gemische auch Ketone wie bspw. Methylethylketon oder höhere Alkohole enthalten. Durch die Zusammensetzung des Lösungsmittelgemisches kann die Grösse der Domänen von Blockcopolymer B gesteuert werden. Besonders geeignet ist ein Lösungsmittelgemisch, das Toluol und Xylol enthält.

Durch die Trocknungsgeschwindigkeit lässt sich die Größe der Domänen des Blockcopolymers B in der kontinuierlichen Phase aus Blockcopolymer A beeinflussen. Die Trocknung der Schicht soll so schnell erfolgen, dass in der Regel nur kleine Domänen von B mit einem Durchmesser von maximal 15 µm, bevorzugt von 5 - 10 µm erhalten werden. Bei einer langsamen Trocknung koagulieren die einzelnen Domänen von B.

Die besonderen Vorteile der erfindungsgemäßen photopolymerisierbaren Druckformen treten bei ihrer Verwendung für die Herstellung von Reliefdruckplatten, insbesondere von Flexodruckplatten, in überzeugender Weise zu Tage. Je nach Aufbau der photopolymerisierbaren Druckform kommen zwei Herstellverfahren in Betracht. Umfasst die photopolymerisierbare Druckform keine IR-empfindliche Schicht, so wird die Struktur der Reliefdruckplatte durch Auflegen einer Bildmaske gefolgt von anschließender Belichtung mit aktinischer Strahlung erzeugt. Umfasst die photopolymerisierbare Druckform eine IR-empfindliche Schicht, so entfällt das Auflegen einer Bildmaske, sondern statt dessen wird die IR-empfindliche Schicht mit einem IR-Laser bildmäßig strukturiert, und so eine Maske auf der photopolymerisierbaren Druckform erzeugt. Anschliessend kann in bekannter Art und Weise durch die so erzeugte Maske mit aktinischem Licht belichtet werden.

Bei Belichtung mit Hilfe einer aufgelegten Bildmaske umfasst die Herstellung der Reliefdruckplatten aus den erfindungsgemäßen photopolymerisierbaren Druckformen im Einzelnen üblicherweise die folgenden Arbeitsgänge:
a) optional Vorbehandeln der erfindungsgemäßen Aufzeichnungsmaterialien,
b) Ablösen der Schutzfolie,
c) Auflegen einer Bildmaske oder Negativvorlage,
d) bildmäßiges Belichten der photopolymerisierbaren Schicht mit aktinischem Licht einer Wellenlänge zwischen 230 und 450, insbesondere 350 und 450 mn,
e) Auswaschen (Entwickeln) der unbelichteten Bereiche der bildmäßig belichteten Schicht mittels geeigneter Entwickler, wobei auch die unbelichteten Bereiche der Oberschicht, sowie die optional vorhandene Entklebungsschicht weggewaschen wird,
f) Trocknen,
g) optional Nachbehandeln der in dieser Weise erhaltenen Reliefdruckplatten, welche nun die Reliefschicht enthalten, oder aus dieser bestehen.

Die Dicke der Reliefschicht variiert je nach Anwendungszweck der Reliefdruckplatten von 0,1 bis 7, insbesondere 0,7 bis 6,5 mm.

Eine übliche Methode der Vorbehandlung ist die vollflächige Belichtung des Aufzeichnungsmaterials von der Rückseite her mit aktinischem Licht. Unter Rückseite ist hier diese Seite zu verstehen, welche der später gebildeten Reliefschicht abgewandt ist.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierte Lampen oder Kohlenbogenlampen.

Beispiele geeigneter Entwickler sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösemitteln; Ketone, wie Aceton oder Methylethylketon; Ether, wie Din-butylether; Ester, wie Essigsäureethylester, halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösemittel enthalten; oder Gemische die eines oder mehrere dieser Lösemittel und zusätzlich noch Alkohole, wie Methanol, Ethanol, Isopropanol oder n-Butanol enthalten; oder Lösemittel und Gemische der genannten Art, die zusätzlich feste, flüssige oder gasförmige organische und anorganische Verbindungen, wie etwa Tenside, in untergeordneten Mengen enthalten.

Übliche Methoden der Nachbehandlung der Reliefbilder oder Druckformen sind das vollflächige Nachbelichten mit aktinischem Licht einer Wellenlänge zwischen 150 und 450 nm oder das Behandeln mit halogenhaltigen, insbesondere bromhaltigen Lösungen.

Im Falle einer photopolymerisierbaren Druckplatte mit IR-empfindlicher Schicht umfasst die Herstellung der Reliefdruckplatten aus den erfindungsgemäßen photopolymerisierbaren Druckformen im Einzelnen üblicherweise die folgenden Arbeitsgänge:
a) Ablösen der Schutzfolie,
b) bildmäßiges Beschreiben der IR-empfindlichen Schicht mit einem IR-Laser,
c) optional Vorbehandeln der erfindungsgemäßen Aufzeichnungsmaterialien,
d) bildmäßiges Belichten der photopolymerisierbaren Schicht mit aktinischem Licht einer Wellenlänge zwischen 230 und 450, insbesondere 350 und 450 mn,
e) Auswaschen (Entwickeln) der unbelichteten Bereiche der bildmäßig belichteten Schicht mittels geeigneter Entwickler, wobei auch die Reste der IR-empfindlichen Schicht die unbelichteten Bereiche der Oberschicht, sowie die optional vorhandene Entklebungsschicht weggewaschen wird,
f) Trocknen
g) optional Nachbehandeln der in dieser Weise erhaltenen Reliefdruckplatten, welche nun die Reliefschicht enthalten, oder aus dieser bestehen.

Die bildmäßige Beschreibung der IR-empfindlichen Schicht mit einem IR-Laser kann zweckmäßigerweise auf einer Trommel erfolgen, auf der die Platte montiert ist. Als Vorteil erweist sich hier der elastomere Charakter der IR-empfindlichen Schicht, durch den die Oberfläche der Platte, die durch die Montage auf die Trommel gespannt wird, nicht beschädigt wird, wie es bei einer nichtelastomeren Schicht der Fall wäre.

Es ist auch möglich, die Reste einer wasser- oder alkohollöslichen IR-empfindlichen Schicht zunächst mit einem Entwickler auf Wasser- bzw. Wasser/Alkoholbasis zu abzulösen und anschließend die Entwicklung der bildmäßig belichteten Schicht mit einem organischen Entwickler durchzuführen. Vorteilhaft wird hierbei der organische Entwickler nicht mit stark färbenden Feststoffen wie bspw. Ruß verunreinigt.

Werden die erfindungsgemäßen photopolymerisierbaren Druckformen dem jeweils entsprechenden Verfahren unterzogen, so wird eine Druckform mit feinen Vertiefungen bzw. Näpfchen in der Oberfläche des druckenden Reliefs erhalten: Unter dem Einfluss der aktinischen Strahlung wird die Photopolymerisation in der photopolymerisierbaren Schicht ausgelöst. Falls die Oberschicht selbst Photoinitiator enthält, wird direkt dort die Photopolymerisation ausgelöst. Bevorzugt enthält die Oberschicht keinen Photoinitiator, und die Photopolymerisation der Oberschicht wird durch die in der direkt darunter liegenden photopolymerisierbaren Schicht erzeugten Radikale ausgelöst. Die beiden Schichten werden somit auch durch chemische Bindungen miteinander verknüpft. Es wird jedoch nur das Blockcopolymere A aus vinylaromatischen und Dienblöcken, welches noch Doppelbindungen im Dienblock enthält vernetzt. Das Blockcopolymere B aus vinylaromatischen und Alkylenblöcken enthält keine Doppelbindungen und wird nicht mit vernetzt. Die sich an der Oberfläche des Reliefs befindlichen Domänen des Blockcopolymeren B werden beim Auswaschen der belichteten Platte ebenfalls herausgewaschen, so dass an dieser Stelle Näpfchen in der Oberfläche des druckenden Reliefs verbleiben. Nur die vollständig von vernetztem und somit unlöslichen Blockcopolymer A umgebenen B-Domänen verbleiben in der ausgehärteten Oberschicht.

In der Regel weisen die Näpfchen im druckenden Relief einen Durchmesser von 5 - 10 µm und eine maximale Tiefe von nicht mehr als 10 µm auf. Die Oberfläche der Druckform wird im Vergleich zu einer Druckform ohne Oberschicht sehr wirksam entklebt. Der Durchmesser der Näpfchen lässt sich durch geeignete Wahl des Lösungsmittels gezielt steuern. So werden beispielsweise in Lösungsmitteln wie Methylethylketon, die das Blockcopolymer B stärker aufquellen können, größere Domänen von B und damit auch Näpfchen größeren Durchmessers erhalten, als mit nicht so stark quellenden Lösungsmitteln. Die Anzahl der Näpfchen pro Flächeneinheit in der Oberfläche des druckenden Reliefs lässt sich sich sehr einfach über das Verhältnis der beiden Blockcopolymere A bzw. B einstellen. Je höher die Anzahl der Näpfchen, desto höher die Rauigkeit der Platte. Somit läßt sich die für ein gewünschtes Druckproblem erforderliche Oberflächenrauigkeit der Druckplatte auf einfache Art und Weise ohne Beeinflussung flexotypischer Eigenschaften der Druckplatte einstellen. Mehr als 50 Gew.-% des nicht vernetzbaren Blockcopolymeren B sollten nicht eingesetzt werden, da sich die Oberschicht bei höheren Gehalten abzulösen beginnt. Gleichfalls sollten nicht weniger als 5 Gew.-% B eingesetzt werden, weil sonst keine Entklebung der druckenden Oberfläche mehr erreicht werden kann. Für die meisten Flexoanwendungen ist in der Regel ein Gewichtsverhältnis Verhältnis A/B zwischen 60:40 und 90:10, insbesondere zwischen 70:30 und 85:15 in der photopolymerisierbaren Druckform vorteilhaft, um zu einer Reliefdruckform mit optimaler Rauigkeit zu kommen.

Ein besonderer Vorteil der erfindungsgemäßen Druckplatten ist die hervorragende Farbannahme und Farbabgabe. Wegen der verringerten Oberflächenklebrigkeit kommt es nicht zum Festkleben von Papierstaub auf der Druckplatte.

Die Platten können nach der Photopolymerisation auch mit Entwicklern auf Basis von Kohlenwasserstofflösemitteln entwickelt werden, ohne dass die Wäscher aufgrund im Entwickler unlöslicher Bestandteile verschlammen.

Die folgenden Beispiele sollen die vorliegende Erfindung erläutern, ohne dass dadurch der Umfang der Erfindung eingeschränkt wird.

Die Oberflächenklebrigkeit der Druckplatten wurde durch die Bestimmung der Pendelklebrigkeit mit einem Erichson-Pendel bestimmt.
Der Pendelkörper besteht aus einem halbrunden Zylinder, der auf der zu prüfenden Oberfläche hin- und herrollen kann. Das Pendel wird auf die zu prüfende Oberfläche abgesenkt, definiert ausgelenkt und schließlich freigegeben. Die Anzahl der Pendelausschläge wird mittels einer Lichtschranke gemessen. Als Vergleichswert wird die Anzahl der Ausschläge mit einer Glasplatte bestimmt.

### Beispiel 1

### Herstellung der Oberschicht:

In einem Rührgefäß mit Zahnscheibendissolver wurde eine Lösung hergestellt bestehend aus:

| | |
|---|---|
| Einsatzstoff: | Menge: |
| Kraton® D 1161 | 22,175 % (vernetzendes Blockcopolymeres) |
| Kraton® G 1652 | 5,54 % (nicht vernetzendes, hydriertes Blockcopolymeres) |
| Kerobit® TBK | 0,20 % |
| Sicodop®-Blau | 0,085 % |
| Toluol | 36,0 % |
| Xylol | 36,0 % |
| | |
| Kraton® D 1161 = | SIS-Dreiblockelastomer; Shell Chemicals Europe |
| Kraton® G 1652 = | SEBS-Dreiblockelastomer, Shell Chemical Company, Houston, USA |
| Kerobit® TBK = | 1,5-Di-tert.-butyl-p-cresol (thermischer Stabilisator, Raschig AG, Ludwigshafen) |
| Sicodop®-Blau = | Pigmentpräparation BASF AG Ludwigshafen, Cu-Phthalocyanin in Dioctylphthalat |

Die Lösemittel wurden vorgelegt, die Pigmentpräparation (Sicodop®-Blau) und der Stabilisator zugegeben, dann Kraton® G 1652 darin gelöst und zuletzt Kraton® D 1161 zugegeben. Die gesamte Mischung wurde dann 30 min. mit dem Zahnscheibendissolver bei Raumtemperatur behandelt. Die erhaltene Lösung hatte eine Viskosität von 2980 mPas bei 23°C.

Die Lösung wurde bei Raumtemperatur mittels eines Gießlineals auf eine mit Macromelt® 6900 (Polyamid der Fa. Henkel Corp., Minneapolis, USA, Schichtdicke 5 µm) beschichtete Polyesterfolie (PET) (Mylar® A, Du Pont Luxembourg, Stärke 125 µm) gegossen und nach der Passage der Trockenzone wieder aufgewickelt. Um ein Verkleben der Gießschicht auf der Rückseite des Polyesters zu verhindern, wurde eine 36 µm silikonisierte PET-Folie als Release-Schicht vor der Aufwicklung auflaminiert (Perlasic® LF 36, Perlen Converting AG, Perlen, CH).

Es wurde ein Schichtenverbund bestehend aus (1) 125 µm-PET-Folie, (2) Polyamid-Schicht, (3) elastomerer Oberschicht und (4) silkonisierter PET-Folie erhalten. Die Dicke der getrockneten elastomeren Oberschicht betrug 70 µm.

### Herstellung des photopolymerisierbaren Gemischs:

Ein lichtempfindliches Gemisch, bestehend aus:

| | | |
|---|---|---|
| 74,97 | Teilen | Styrol-Isopren-Styrol-Dreiblockelastomer (Kraton® D1161) |
| 5 | Teilen | α-Methylstyrol/Vinyltoluol-Copolymer (Piccotex® 100, Hercules Inc., Wilmington, USA) |
| 5 | Teilen | Hexandioldimethacrylat |
| 5 | Teilen | Hexandioldiacrylat |
| 7 | Teilen | Paraffinöl (Weißöl S 5000) |
| 1 | Teil | mikrokristallines Paraffinwachs |
| 1 | Teil | Benzildimethylketal |
| 1 | Teil | Kerobit® TBK |
| 0,03 | Teilen | Sudanorange fl. 183 |

wurde in einem Zweischneckenextruder (ZSK 53) mit einem Durchsatz von 30 kg/h bei einer Massetemperatur von 130°C extrudiert und durch eine Breitschlitzdüse ausgetragen. Die aus der Düse ausgetragene Schmelze wurde in den Spalt eines Zweiwalzenkalanders eingeführt. Beide Walzen waren auf 80°C beheizt.

Über die obere Kalanderwalze wurde eine mit einem Haftlack beschichtete 125 µm dicke Polyethylenterephthalatfolie (Mylar®) eingeführt, über die untere Kalanderwalze die mit der Oberschicht beschichtete Polyesterfolie, von der mittels einer automatischen Aufwicklung die auflaminierte Release-Folie abgezogen wurden. Zwischen dem Abziehen der Release-Folie und dem Kalander wurde die Oberfläche der Toplayer coronabehandelt (Coronabehandlungsstation der Fa. Kalwar). Die Bahnbreite betrug 50 cm, die Geschwindigkeit 60 cm/min, der Kalanderspalt 3000 µm. Der erhaltene Sandwich-Verbund wurde über ein Saugband transportiert, abgekühlt und konfektioniert. Die Gesamtstärke der photopolymerisierbaren Druckform inklusive aller Folien betrug 3010 µm.

### Herstellung des Druckklischees:

Nach einer Woche Lagerzeit wurden die Rohplatten zu Klischees verarbeitet. Folgende Verarbeitungsschritte wurden durchgeführt:
a. Vollflächige rückseitige Belichtung mit UV-Licht (F III-Belichter, BASF, 35s),
b. Abziehen der Schutzfolie,
c. Auflegen eines nyloflex® FAR II-Testfilms (BASF),
d. Hauptbelichtung unter der Vakuumfolie (F III Belichter, 3-30 min in 3 min-Schritten)
e. Auswaschen der Platte (Durchlaufsystem VFIII, BASF, Durchlaufgeschwindigkeit 150mm/min, Auswaschmittel (auf Basis Kohlenwasserstofflösungsmitteln) nylosolv® II von BASF, 30°C, Relieftiefe 1000µm)
f. 2 Stunden Trocknen bei 65°C
g. Nachbelichtung (UVA, F III Belichter, 15min)
h. Nachbehandeln mit UVC-Licht (F III Nachbehandlungsgerät, BASF, 15min)

Das Testklischee wurde ausgewertet. Beurteilt wurde, bei welcher Belichtungszeit die Positiv-Testelemente (freistehender Punkt 200 µm, Gitter 55 µm und das 2 %-Tonwert-Rasterfeld (60L/cm) auf dem Klischee korrekt ausgebildet waren. Der Zeitpunkt, zu dem alle Positivelemente korrekt ausgebildet sind, wird als Untere Belichtungsgrenze (UBG), d.h. die Mindestbelichtungsdauer für eine korrekte Abbildung, bezeichnet.

Darüber hinaus wurden auch die Negativelemente, d.h. der 400 µm-Negativpunkt und der 2000 µm-Graben beurteilt. Unterschreitet die Tiefe im Negativpunkt 70 µm bzw. im Graben 500 µm ist eine korrekte Farbübertragung nicht mehr gewährleistet. Der Zeitpunkt, zu dem mindestens eines der beiden Negativelemente diese Grenzen unterschreitet, wird als Obere Belichtungsgrenze (OBG), d.h. maximale Belichtungsdauer für ein brauchbares, Klischee bezeichnet. Die Differenz von OBG-UBG ergibt den sog. Belichtungsspielraum (BSR), der für eine praxisgerechte Anwendung positiv sein muß.

Für die im obigen Beispiel hergestellte Platte ergeben sich folgende Werte:

| | |
|---|---|
| 200µm-Positivpunkt | 15 min |
| 55µm-Gitter | 18 min |
| 2 %-Raster (60L/cm) | 15 min |
| 400µm-Negativpunkt | 27 min |
| 2000µm-Graben | 24 min |
| UBG: | 18 min |
| OBG: | 24 min |
| BSR: | 6 min |

Des weiteren wurde die Pendelklebrigkeit der Druckplatte mit einem Erichsson-Pendel gegen Glas als Referenz bestimmt:

| Meßobjekt | Pendelausschläge |
|---|---|
| Glas (Referenz) | 435 |
| Druckplatte ohne Oberschicht (Nyloflex® FAR II, BASF) | 62 |
| Beispiel 1 | 134 |

Die Oberflächenklebrigkeit konnte im Vergleich zu einer Druckplatte ohne Oberschicht deutlich verringert werden. Die Druckqualität im Rasterbereich ist deutlich besser als bei einer Druckplatte ohne Oberschicht. Die Platte zeigt einen spitzeren Ausdruck, eine geringere Tonwertzunahme und weichere Verläufe.

Die Ergebnisse sind in Tabelle 1 zusammengefasst.

### Beispiel 2:

Es wurde wie in Beispiel 1 vorgegangen, nur wurde zur Einfärbung der Oberschicht anstelle eine Cu-Phthalocyaninpigmentes ein Perylenpigment (Paliogenrot®) eingesetzt.

Für die Oberschicht wurde eine Pigmentpräparation in toluolischer Kautschuklösung hergestellt.

Dazu wurden

| | |
|---|---|
| 13 | Teile Paliogenrot® EC 7265 |
| 12,1 | Teile Kraton® D1161 und |
| 74,9 | Teile Toluol |

vermischt und nach dem Zusatz von Glasperlen (Durchmesser 3-4 mm, 210 ml/kg Dispersion) wurde 4 Stunden auf einem Rollbrett dispergiert, abgekühlt und durch Abgießen über ein 1 mm-Sieb von den Mahlkörpern getrennt (millbase-recovery 90 %). Es wurde eine sehr stabile und feinteilige Pigmentdispersion für die Einfärbung der Oberschicht erhalten.

Analog Beispiel 1 wurden Oberschichten hergestellt und verarbeitet.

| Einsatzstoff: | Menge: |
|---|---|
| Kraton® D 1161 | 21,66 % |
| Kraton® G 1652 | 5,54 % |
| Kerobit® TBK | 0,20 % |
| Paliogenrot®-Disp. | 0,60 % (13 % Feststoffgehalt) |
| Toluol | 36,0 % |
| Xylol | 36,0 % |

Die Oberschicht wurde wie in Beispiel 1 zu einer photopolymerisierbaren Druckform verarbeitet, belichtet und zu einer Druckplatte verarbeitet. Wie in Beispiel 1 wurde der Belichtungsspielraum sowie die Klebrigkeit bestimmt. bestimmt. Die Ergebnisse sind in Tabelle 1 zusammengefasst.

### Beispiele 3 - 5 (Einfärbung mit Polymerfarbstoffen)

Es wurde wie in Beispiel 1 vorgegangen, nur wurden anstelle eines Cu-Phthalocyaninpigmentes zur Einfärbung verschiedene polymere, lichtechte Azofarbstoffe (Reactint®, Milliken) eingesetzt.

Tabelle 1 fasst die Ergebnisse der Versuche zusammen.

### Beispiel 6:

Es wurde wie in Beispiel 1 vorgegangen, nur wurde als nichtvernetzendes Bindemittel 2 eines mit höherem Molekulargewicht (Kraton® G 1650) eingesetzt. Die Ergebnisse sind in Tabelle 1 zusammengefasst.

### Beispiele 7 - 10, Vergleichsbeispiel 1 - 3 (Oberflächenrauhigkeit)

Es wurde wie Beispiel 1 vorgegangen, aber das Verhältnis von SIS-Kautschuk (Kraton® D1161) zu SEBS-Kautschuk (Kraton® G1652) wurde verändert. Von den erhaltenen Druckplatten wurde jeweils die Klebrigkeit und die Rauhigkeit gemessen.

Drucktechnisch und vom Entklebungsergebnis hat sich das Verhältnis 80:20 als optimal herausgestellt. Wird SIS-Kautschuk eingesetzt, so klebt die Oberfläche wieder zuviel. Bei sehr hohen SEBS-Gehalten (>50 %) kommt es zu Ablösungen der Oberschicht, da die Schicht nicht mehr richtig auf der Oberfläche des Photopolymers haftet.

Die Ergebnisse sind in Tabelle 2 zusammengefasst.

### Vergleichsbeipiele 4 - 9

Es wurde wie in Beispiel 1 vorgegangen, nur wurde als Bindemittel 2 verschiedene nicht-hydrierte SIS- oder SBS-Kautschuke eingesetzt. Mit keinem dieser Bindemittel konnte eine klebfreie Oberfläche erhalten werden. Die Ergebnisse sind in Tabelle 3 zusammengefasst.

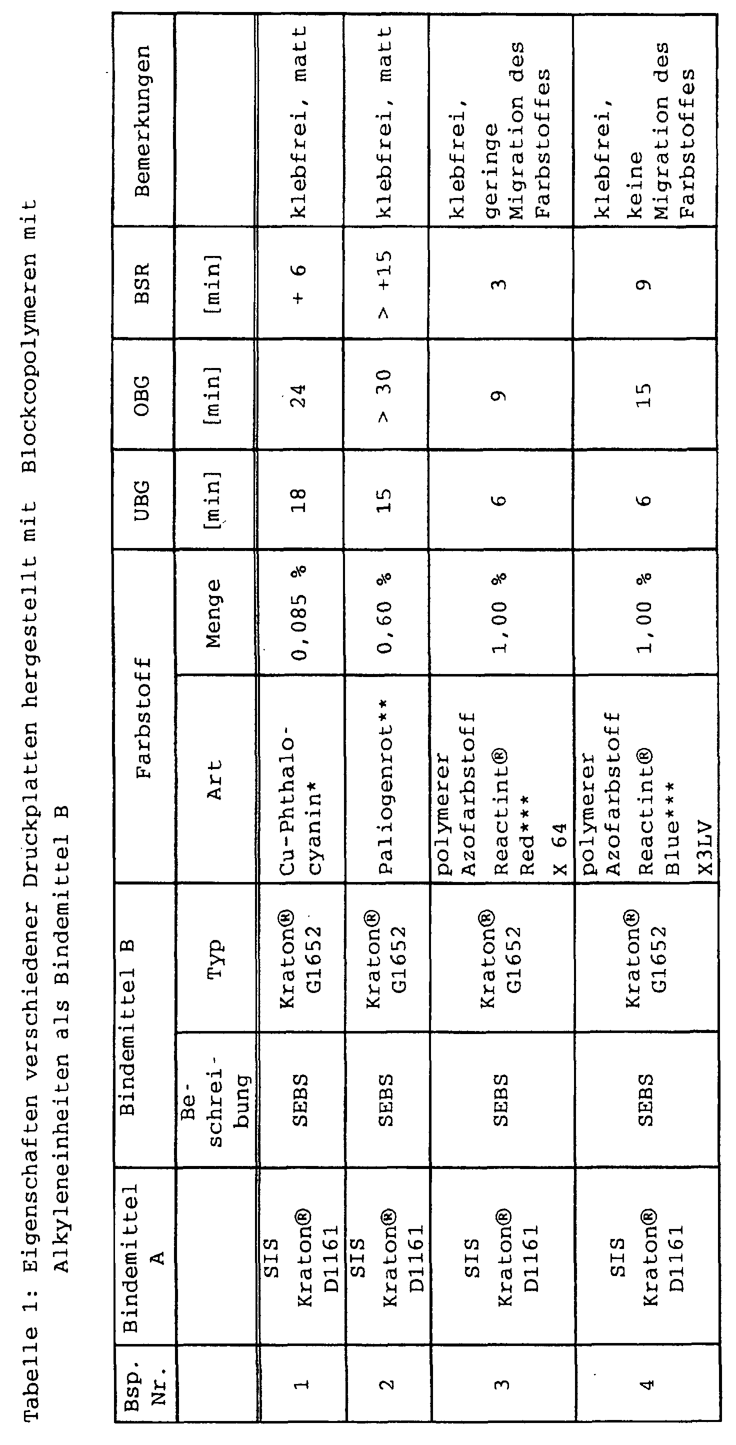

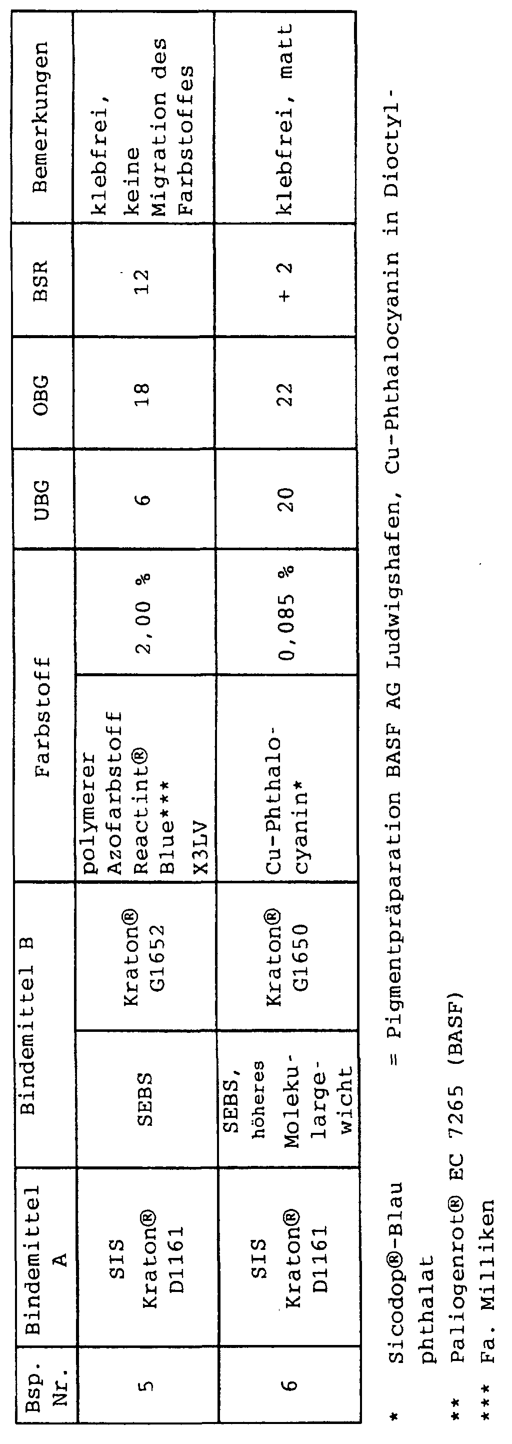

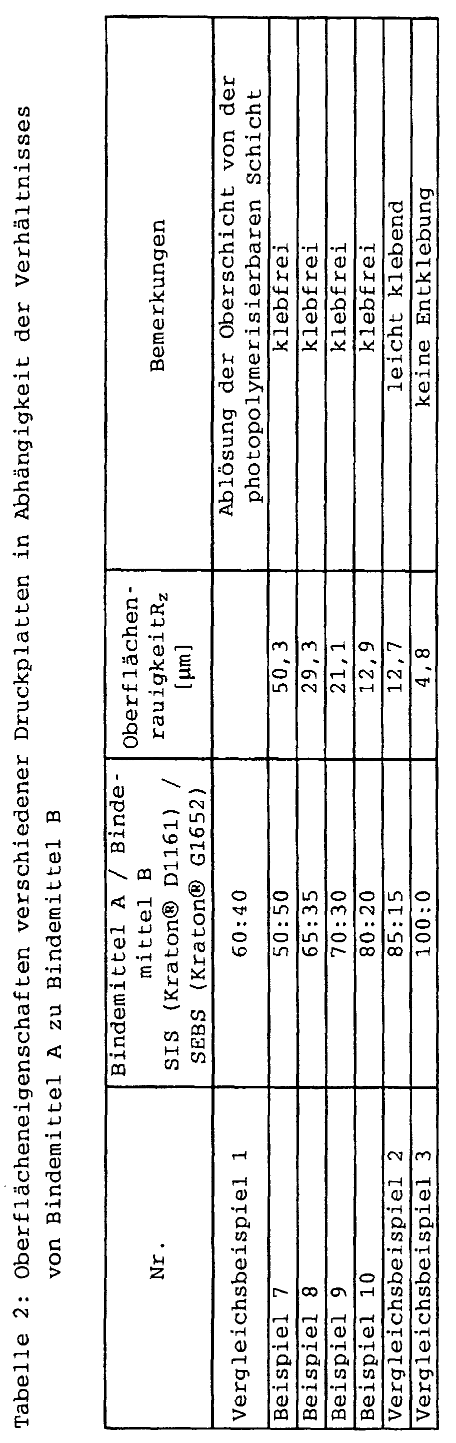

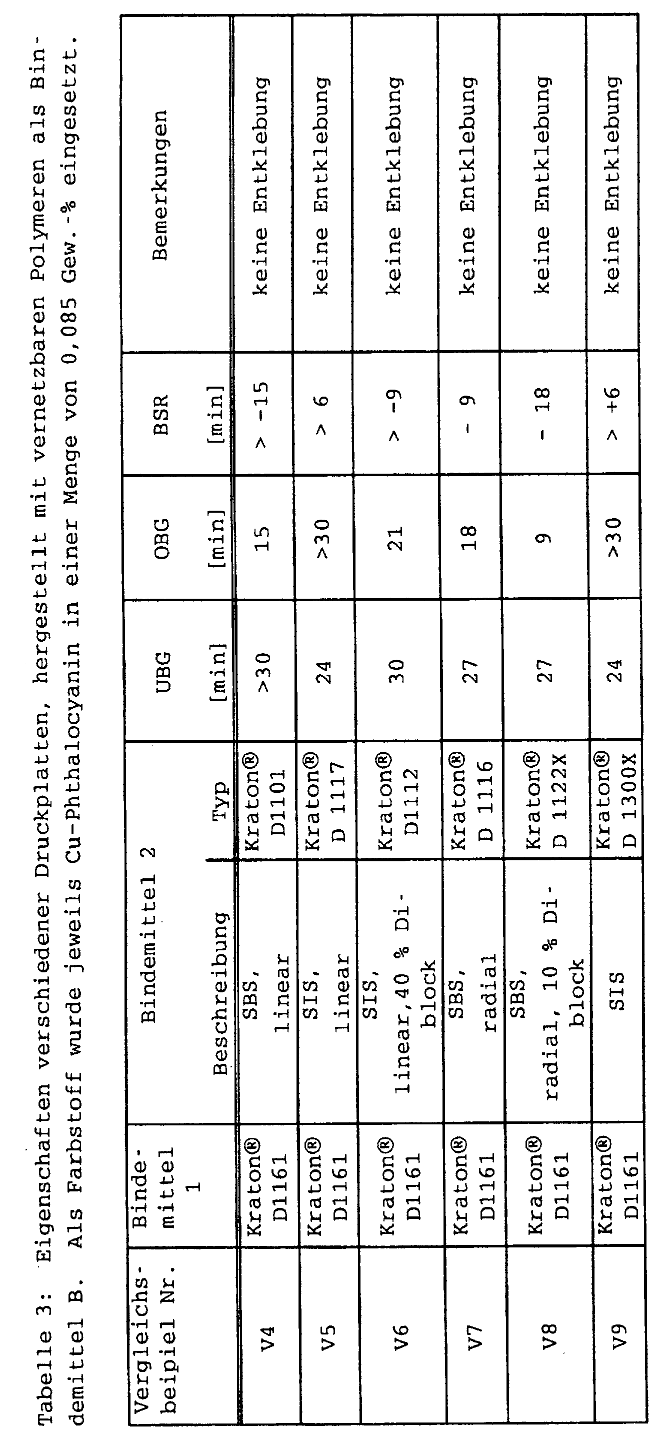

Die Beispiele zeigen, dass nur mit Blockcopolymeren mit gesättigten Alkylenblöcken als Bindemittel B Druckklischees mit klebfreier Oberfläche und einem positiven Belichtungsspielraum erhalten werden können. Das beste Ergebnis liefert das in Beispiel 1 verwendete SEBS-Bindemittel Kraton® G 1652. Durch Veränderung des Verhältnisses von Blockcopolymer A mit Dienblock zu Blockcopolymer B mit Alkylenblock kann auf einfache Art und Weise die Rauhigkeit der Oberfläche der Druckplatte eingestellt werden.

Die Oberschicht kann sowohl mit Farbpigmenten wie mit Farbstoffen eingefärbt werden. Besonders vorteilhaft ist die Verwendung polymerer Farbstoffe mit denen sich besonders schnelle Platten, d.h. mit kurzen Belichtungszeiten und dennoch guten Belichtungsspielräume erhalten lassen.

## Patentansprüche

1. Photopolymerisierbare Druckform umfassend einen dimensionsstabilen Schichtträger, eine photopolymerisierbare Schicht, eine darauf aufgebrachte elastomere Oberschicht und eine Schutzfolie,
**dadurch gekennzeichnet, dass** die elastomere Oberschicht
• 40 - 95 Gew.-% eines vernetzbaren elastomeren Blockcopolymeren A aus vinylaromatischen und Dienblöcken, sowie
• 5 - 50 Gew.-% eines nicht vernetzbaren elastomeren Blockcopolymeren B aus vinylaromatischen und Alkylenblöcken enthält,
und die Blockcopolymere A und B nicht miteinander verträglich sind.

2. Photopolymerisierbare Druckform gemäß Anspruch 1, **dadurch gekennzeichnet, dass** sie auf der Oberschicht zusätzlich eine IR-ablatierbare Schicht mit einer hohen Absorption im Wellenlängenbereich zwischen 750 und 20000 nm und einer optischen Dichte im aktinischen Bereich von mindestens 2,5 trägt.

3. Photopolymerisierbare Druckform gemäß Ansprüchen 1 oder 2 **dadurch gekennzeichnet, dass** das elastomere Blockcopolymere A aus Polystyrolblöcken und Polybutadien- oder Polyisoprenblöcken besteht.

4. Photopolymerisierbare Druckform gemäß Ansprüchen 1 bis 3 **dadurch gekennzeichnet, dass** das elastomere Blockcopolymere B aus Polystyrolblöcken und Polyethylen/butylen- oder Polyethylen/propylenblöcken besteht.

5. Photopolymerisierbare Druckform gemäß Ansprüchen 1 bis 4 **dadurch gekennzeichnet, dass** die elastomere Oberschicht einen migrationsstabilen Farbstoff oder ein migrationsstabiles Farbpigment enthält.

6. Verfahren zur Herstellung einer photopolymerisierbaren Druckform nach Ansprüchen 1 bis 5 **dadurch gekennzeichnet, dass** man folgende Schritte ausführt:
• Lösen der elastomeren Blockcopolymere A und B sowie gegebenenfalls weiterer Bestandteile in einem organischen Lösungsmittel,
• Aufgießen dieser Lösung auf eine mit einer Entklebungsschicht und optional mit einer IR-ablativen Schicht beschichteten Schutzfolie,
• Verdampfen des Lösungsmittelgemischs, so dass die beiden elastomeren Blockcopolymere entmischen, sowie
• Aufbringen des hergestellten Schichtenverbundes auf eine photopolymerisierbare Schicht auf dimensionsstabilem Träger.

7. Verfahren zur Herstellung einer photopolymerisierbaren Druckform nach Anspruch 6, **dadurch gekennzeichnet, dass** es sich bei dem organischen Lösungsmittel um ein Toluol und Xylol enthaltendes Gemisch handelt.

8. Verfahren zum Herstellen von Reliefdruckformen, **dadurch gekennzeichnet, dass** man eine photopolymerisierbare Druckform gemäß einem der Ansprüche 1, 3 bis 5 nach Abziehen der Schutzfolie mit einer Filmmaske bedeckt, bildmäßig mit aktinischem Licht bestrahlt und nach Belichtung durch Auswaschen der unbelichteten Schichtbereiche mit einem Entwickler entwickelt.

9. Verfahren zum Herstellen von Reliefdruckformen, **dadurch gekennzeichnet, dass** man nach Abziehen der Schutzfolie die gegen IR-Strahlung empfindliche Schicht einer photopolymerisierbaren Druckform nach einem der Ansprüche 2 bis 5 mit einem IR-Laser bildmäßig strukturiert und so eine Maske auf der photopolymerisierbaren Schicht erzeugt, anschließend bildmäßig mit aktinischem Licht bestrahlt und nach Belichtung durch Auswaschen der unbelichteten Schichtbereiche mit einem Entwickler entwickelt.

10. Reliefdruckform, hergestellt nach Anspruch 8 oder 9, **dadurch gekennzeichnet, dass** sich in der Oberfläche des Reliefs Näpfchen befinden.

11. Reliefdruckform nach Anspruch 10 **dadurch gekennzeichnet, dass** die Näpfchen einen Durchmesser von maximal 10 µm und eine Tiefe von maximal 10 µm aufweisen.

## Claims

1. A photopolymerizable printing plate comprising a dimensionally stable layer support, a photopolymerizable layer, an elastomeric top layer applied thereon, and a protective sheet,
wherein said elastomeric top layer comprises
• 40 - 95% by weight of a crosslinkable elastomeric block copolymer A comprising vinylaromatic blocks and diene blocks, and
• 5 - 50% by weight of a noncrosslinkable elastomeric block copolymer B comprising vinylaromatic blocks and alkylene blocks,
and the block copolymers A and B are mutually incompatible.

2. A photopolymerizable printing plate as claimed in claim 1, further carrying on the top layer an IR-ablatable layer having high absorption in the wavelength range between 750 and 20,000 nm and an optical density in the actinic region of at least 2.5.

3. A photopolymerizable printing plate as claimed in claim 1 or 2, wherein said elastomeric block copolymer A consists of polystyrene blocks and polybutadiene blocks or polyisoprene blocks.

4. A photopolymerizable printing plate as claimed in any of claims 1 to 3, wherein said elastomeric block copolymer B consists of polystyrene blocks and polyethylene/butylene blocks or polyethylene/propylene blocks.

5. A photopolymerizable printing plate as claimed in any of claims 1 to 4, wherein said elastomeric top layer comprises a migration-stable dye or a migration-stable color pigment.

6. A process for producing a photopolymerizable printing plate as claimed in any of claims 1 to 5, which comprises performing the following steps:
• dissolving said elastomeric block copolymers A and B and, if desired, further constituents in an organic solvent,
• pouring this solution onto a protective sheet coated with an abhesive layer and, optionally, with an IR-ablative layer,
• evaporating the solvent mixture so that the two elastomeric block copolymers separate, and
• applying the layer assembly thus produced to a photopolymerizable layer on said dimensionally stable support.

7. A process for producing a photopolymerizable printing plate as claimed in claim 6, wherein said organic solvent is a mixture comprising toluene and xylene.

8. A process for producing a relief printing plate, which comprises covering a photopolymerizable printing plate as claimed in any of claims 1 and 3 to 5 with a film mask after having removed the protective sheet, subjecting the masked plate to imagewise exposure with actinic light, and, following exposure, developing the plate by washing out the unexposed layer regions with a developer.

9. A process for producing a relief printing plate, which comprises, after having removed the protective sheet, subjecting the IR-sensitive layer of a photopolymerizable printing plate as claimed in any of claims 2 to 5 to imagewise structuring using an IR laser, so producing a mask on the photopolymerizable layer, then subjecting the plate to imagewise exposure with actinic light, and, after exposure, developing the plate by washing out the unexposed layer regions with a developer.

10. A relief printing plate produced as claimed in claim 8 or 9, wherein ink cells are located in the surface of the relief.

11. A relief printing plate as claimed in claim 10, wherein said ink cells have a diameter of not more than 10 µm and a depth of not more than 10 µm.

## Revendications

1. Plaque d'impression photopolymérisable comprenant un support de couche à stabilité dimensionnelle, une couche photopolymérisable, une couche supérieure élastomère appliqué par-dessus et une feuille protectrice,
**caractérisée en ce que** la couche supérieure élastomère contient
- un copolymère séquencé A élastomère et réticulable constitué de séquences diène et de séquences vinylaromatiques à raison de 40% à 95% en poids, ainsi que
- un copolymère séquencé B élastomère et non réticulable constitué de séquences alcène et de séquences vinylaromatiques à raison de 5% à 50% en poids,
et **en ce que** les copolymères séquencés A et B ne sont pas compatibles.

2. Plaque d'impression photopolymérisable selon la revendication 1, **caractérisée en ce qu'**elle porte en sus sur la couche supérieure une couche pouvant être ablatée par exposition aux IR et présentant une forte absorption dans le domaine spectral compris entre 750 nm et 20 000 nm et une densité optique d'au moins 2,5 dans la plage actinique.

3. Plaque d'impression photopolymérisable selon les revendications 1 ou 2, **caractérisée en ce que** le polymère séquencé élastomère A est constitué de séquences de polystyrène et de séquences de polybutadiène ou de polyisoprène.

4. Plaque d'impression photopolymérisable selon les revendications 1 à 3, **caractérisée en ce que** le polymère séquencé élastomère B est constitué de séquences de polystyrène et de séquences de polyéthylène/butylène ou polyéthylène/propylène.

5. Plaque d'impression photopolymérisable selon les revendications 1 à 4, **caractérisée en ce que** la couche supérieure élastomère comprend un colorant stable à la migration ou un pigment pour colorants stable à la migration.

6. Procédé de préparation d'une plaque d'impression photopolymérisable selon les revendications 1 à 5, **caractérisée en ce que** l'on réalise les étapes suivantes :
- dissolution des copolymères séquencés d'élastomères A et B ainsi que des composants supplémentaires qui sont éventuellement présents dans un solvant organique,
- application de cette solution sur une feuille protectrice revêtue d'une couche anti-adhésive et éventuellement d'une couche pouvant être ablatée par exposition aux IR,
- évaporation du mélange de solvant afin que les deux copolymères élastomères séquencés se séparent, ainsi que
- application de la composition de couches préparée sur une couche photopolymérisable située sur un support à stabilité dimensionnelle.

7. Procédé de préparation d'une plaque d'impression photopolymérisable selon la revendication 6, **caractérisée en ce que** le solvant organique est constitué d'un mélange contenant le toluène et le xylène.

8. Procédé de préparation d'une forme d'impression en relief **caractérisé en ce que** l'on recouvre la plaque d'impression photopolymérisable selon l'une des revendications 1, 3 à 5, d'un masque de film après avoir retiré la feuille de recouvrement, **en ce que** l'on l'irradie avec une lumière actinique en formant une image et **en ce que** l'on développe, après exposition, avec un révélateur en éliminant par lavage les zones de couche non exposées.

9. Procédé de préparation d'une forme d'impression en relief, **caractérisé en ce qu'**après avoir enlevé la feuille protectrice, la couche sensible au rayonnement IR d'une forme d'impression photopolymérisable selon l'une des revendications 2 à 5 est structurée avec un laser IR en formant une image et en produisant ainsi un masque sur la couche photopolymérisable, **en ce que** l'on irradie ensuite en formant une image avec une lumière actinique et après exposition, on développe avec un révélateur en éliminant les zones non exposées de la couche par lavage.

10. Forme d'impression en relief que l'on a préparé selon la revendication 8 ou 9, **caractérisée en ce que** la surface du relief présente des creux.

11. Forme d'impression en relief selon la revendication 10, **caractérisée en ce que** les creux présentent un diamètre de 10 µm au maximum et une profondeur de 10 µm au maximum.
